(19) Europäisches Patentamt
European Patent Office
Office européen des brevets

(11) **EP 3 855 518 B1**

(12) **EUROPEAN PATENT SPECIFICATION**

(45) Date of publication and mention
of the grant of the patent:
**11.06.2025 Bulletin 2025/24**

(51) International Patent Classification (IPC):
*H10N 10/17* (2023.01)      *H10N 10/851* (2023.01)

(52) Cooperative Patent Classification (CPC):
**H10N 10/17; H10N 10/8556**

(21) Application number: **20217979.2**

(22) Date of filing: **31.12.2020**

(54) **THERMOELECTRIC CONVERSION MODULE**

MODUL ZUR THERMOELEKTRISCHEN UMWANDLUNG

MODULE DE CONVERSION THERMOÉLECTRIQUE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **27.01.2020 JP 2020010771**

(43) Date of publication of application:
**28.07.2021 Bulletin 2021/30**

(73) Proprietor: **Hitachi, Ltd.**
**Tokyo 100-8280 (JP)**

(72) Inventors:
• **OKAMOTO, Masakuni**
  **Chiyoda-ku, Tokyo 100-8280, (JP)**
• **FUKATANI, Naoto**
  **Chiyoda-ku, Tokyo 100-8280, (JP)**
• **HAYAKAWA, Jun**
  **Chiyoda-ku, Tokyo 100-8280, (JP)**

(74) Representative: **Mewburn Ellis LLP**
**Aurora Building**
**Counterslip**
**Bristol BS1 6BX (GB)**

(56) References cited:
**EP-A1- 1 970 972      EP-B1- 1 970 972
EP-B1- 2 854 189      WO-A1-2017/057259
US-A1- 2002 024 154**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

Technical Field

The present disclosure relates to a thermoelectric conversion module and a thermoelectric assembly.

Background Art

The NEDO and TherMAT National Project has developed a thermoelectric conversion module for cogeneration that can improve power efficiency by 5% (for example, output of 10 kW/m$^2$ in the cogeneration of 35kW class) from exhaust heat (from 300°C to 600°C) of cogeneration. In the cogeneration, while 30% of total fuel energy is wasted as heat, there is a demand to increase electricity even by 1%. An improvement of about 3% in a gas engine installed in the cogeneration is possible by improving the engine, but further improvement requires other improvement technologies.

In general, a thermoelectric conversion module is configured by combining a p-type thermoelectric conversion material and an n-type thermoelectric conversion material. Thus, in order to obtain high thermoelectric conversion characteristics in the thermoelectric conversion module, it is obviously desired to obtain a high performance index ZT for both p-type and n-type thermoelectric conversion materials. Furthermore, performance can be maximized by optimizing the structure in accordance with element characteristics peculiar to the materials used.

In this regard, for example, in Patent Literature 1, a cross-sectional area ratio of the p-type element and the n-type element for maximizing the characteristics is specified as p-type: n-type = t: 1 - t, where $0.42 \leq t \leq 0.6$ (see paragraph [0059] of Patent Literature 1). This is an optimum structure for thermoelectric elements based on an Fe-Ti-Si ternary system.

Further, for example, in Patent Literature 2, although a material system of the thermoelectric element is not shown, the cross-sectional area ratio t is defined as $0.6 \leq t \leq 0.74$.

WO 2017/057259 A1 refers to a thermoelectric conversion module and thermoelectric conversion device. EP 1 970 972 A1 discloses a manufacturing method of thermoelectric converter.

Citation List

Patent Literature

   Patent Literature 1: JP 2015-122476 A
   Patent Literature 2: JP H11-274577 A

Summary of Invention

Technical Problem

In a n-type module that combines a p-type element and an n-type element of ZT = 1 class, a power generation output changes depending on a module structure (element area and element thickness) and a heat source surface area which is a factor of a heat transfer capacity of the heat exchange part.

However, in the conventional art represented by Patent Literatures 1 and 2, structural factors of the thermoelectric conversion module have not been optimized, and a maximum power output has not yet been obtained.

In view of such circumstances, the present disclosure provides a thermoelectric conversion module that further improves power efficiency from exhaust heat of cogeneration.

Solution to Problem

In order to solve the above problem, the subject matter of claim 1 is provided. The present disclosure proposes, for example, a thermoelectric assembly comprising a thermoelectric conversion module and heat supply units, wherein the thermoelectric conversion module comprises a p-type thermoelectric conversion material and an n-type thermoelectric conversion material, each of which is a silicide material based on a binary system, wherein the thermoelectric assembly includes multiple thermoelectric conversion modules, wherein the heat supply units are disposed on an upper surface and a lower surface in a thickness direction of the thermoelectric conversion module, are configured to impart a temperature difference to the thermoelectric conversion module, and are configured to supply heat for power generation by Seebeck effect of the p-type and n-type thermoelectric conversion materials and cooling source discharging heat, wherein the p-type and n-type thermoelectric conversion materials have a cross-sectional area ratio t satisfying:

the p-type thermoelectric conversion material : the n-type thermoelectric conversion material = t: 1 - t, where 0.5 < t < 0.7, and a length L of a thermoelectric element satisfying L ≤ 5 mm, wherein, when cross-sectional areas where electrodes for discharging the heat from the p-type thermoelectric conversion material having a cross-sectional area $A_p$ and the n-type thermoelectric conversion material having a cross-sectional area $A_n$ are in contact with the cooling source are $A_p'$ and $A_n'$, respectively, the thermoelectric conversion module has an area ratio of $A_p'/A_p \geq$ 0.73 and $A_n'/A_n \geq 0.73$.

More features of the present disclosure will be apparent from the description of the present specification and the accompanying drawings. The aspects of the present disclosure are achieved and implemented by the elements, combinations of various elements, the following detailed description, and the aspects of the appended claims.

Advantageous Effects of Invention

The technology of the present disclosure can achieve a thermoelectric conversion module having a maximum power output exceeding 10 kW/m$^2$ (equivalent to a conversion efficiency of 5%).

Brief Description of Drawings

Fig. 1 is a diagram showing a configuration example of a single-pair thermoelectric conversion module 100.
Fig. 2 is a diagram showing a configuration example of an electrical equivalent circuit of the single-pair thermoelectric conversion module 100.
Fig. 3 is a diagram schematically showing a state of cross-sectional areas $A_p$ and $A_n$.
Fig. 4 is a diagram showing a state of cross-sectional areas in a multiple-pair module.
Fig. 5 is a graph showing calculation results of a maximum power output per unit area $P_{max}/A_{tot}$ with respect to a cross-sectional area ratio t.
Fig. 6 is a graph showing the calculation results of the maximum power output per unit area $P_{max}/A_{tot}$ with respect to a length L of an element, using an effective heat transfer coefficient h* as a parameter. The maximum power output per unit area for a length L of an element is plotted. The effective heat transfer coefficient is used as a parameter. In water cooling (forced convection), the heat transfer coefficient is h = 3,000 to 7,000 (W/m$^2$K).
Fig. 7 is a graph showing results of the maximum power output (Module-2 to Module-6) per unit area with respect to the length L of an element. The experimental results are shown in addition to the calculation results in Fig. 6.

Description of Embodiments

The embodiment of the present disclosure is based on our binary silicide material (which is distinctively different from Patent Literatures 1 and 2). Further, in the present embodiment, the structure is optimized in consideration of heat transfer regarding an outlet of a heat flow (which is different from Patent Literature 1).

In the present embodiment, the cross-sectional area ratio of the p-type thermoelectric conversion element and the n-type thermoelectric conversion element manufactured from a silicide material based on the binary system configuring the thermoelectric conversion module is optimized and the cross-sectional area of the electrodes at the outlet of the heat flow is optimized, thereby achieving a maximum power output (the power output of the thermoelectric conversion module using a silicide material based on the binary system is maximized). Hereinafter, examples according to the present embodiment will be described. In the examples, the description is given in sufficient detail for those skilled in the art to implement the technology of the present disclosure. However, other implementations and forms are also possible, and it is to be understood that a configuration or structure can be changed and various elements can be replaced without departing from the scope of the technical idea of the present disclosure. Therefore, the following description is not to be construed solely by the examples.

[Example 1]

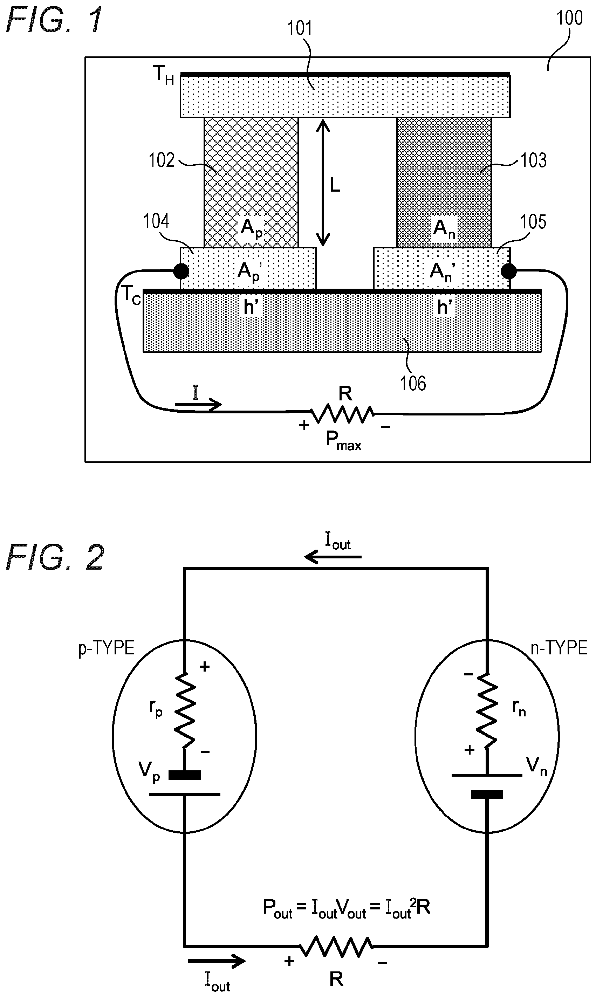

Fig. 1 is a diagram showing a configuration example of a single-pair thermoelectric conversion module 100. Fig. 2 is a diagram showing a configuration example of an electrical equivalent circuit of the single-pair thermoelectric conversion module 100.

Performance of the single-pair thermoelectric conversion module 100 is derived from the electrical equivalent circuit shown in Fig. 2. Using the symbols in Fig. 2, Equation (1) is established for voltage.
[Math. 1]

$$V_p - I_{out}r_p + V_n - I_{out}r_n - I_{out}R = 0 \quad \cdots (1)$$

From equation (1), output $P_{out}$ can be obtained as in Equation (2).
[Math. 2]

$$P_{out} = I_{out}V_{out} = I_{out}^2 R \quad \cdots (2)$$

The maximum power output $P_{max}$ of the thermoelectric conversion module is represented as in Equation (3).
[Math. 3]
In the case of $R = r_p + r_n$ :

$$P_{max} = \frac{1}{4} \cdot \frac{(V_p + V_n)^2}{r_p + r_n} \quad \cdots (3)$$

Here, an internal resistances $r_p$ and $r_n$ can be obtained from Equation (4).
[Math. 4]

$$r_p = \int_0^L \frac{\rho_p(x)}{A_p}dx \qquad r_n = \int_0^L \frac{\rho_n(x)}{A_n}dx \quad \cdots (4)$$

Here, $\rho_p$ and $\rho_n$ are electrical resistivities in a length direction of the p-type and n-type thermoelectric conversion elements, respectively. Furthermore, generated voltages $V_p$ and $V_n$ can be obtained from a temperature integration of Seebeck coefficients ($S_p$ and $S_n$) as in Equation (5).
[Math. 5]

$$V_p = \int_0^L S_p(T)\frac{dT}{dx}dx \qquad V_n = -\int_0^L S_n(T)\frac{dT}{dx}dx \quad \cdots (5)$$

A temperature difference is smaller than an environmental temperature difference $\Delta T = T_H - T_C$. This is because a thermal resistance is generated due to the heat transfer coefficient at an interface and thermal conductivity of the thermoelectric conversion element. As a result, the temperature difference generated at both ends of the element is represented as in Equation (6).
[Math. 6]

$$\Delta T_p = \frac{\Delta T}{1 + \left(\frac{1}{h_p} + \frac{1}{h_p^*}\right)\frac{\kappa_p}{L}} \qquad \Delta T_n = \frac{\Delta T}{1 + \left(\frac{1}{h_n} + \frac{1}{h_n^*}\right)\frac{\kappa_p}{L}} \quad \cdots (6)$$

Here, $h_p$ is the heat transfer coefficient at the interface between a high temperature electrode and the p-type thermoelectric conversion element, $h_p^*$ is the effective heat transfer coefficient of a low temperature electrode, and $h_n$ and $h_n^*$ are defined similarly. The effective heat transfer coefficient is defined as in Equation (7).
[Math. 7]

$$\frac{1}{h_p^*A_p} = \frac{1}{h_pA_p} + \frac{d}{\kappa A_p'} + \frac{1}{h'A_p'} \qquad \frac{1}{h_n^*A_n} = \frac{1}{h_nA_n} + \frac{d}{\kappa A_n'} + \frac{1}{h'A_n'} \quad \cdots (7)$$

Here, d is a thickness of the electrode and $\kappa$ is the thermal conductivity of the electrode. Considering that the electrodes are thin and have high thermal conductivity and that the heat transfer coefficient is smaller at a water-cooling interface than at an element interface, Equation (7) can be approximately represented by the following Equation (8).
[Math. 8]

$$h_p^* \approx \frac{h' A_p'}{A_p} \qquad h_n^* \approx \frac{h' A_n'}{A_n} \qquad \cdots (8)$$

Here, h' is the heat transfer coefficient of water cooling, $A_p$ and $A_n$ are the cross-sectional areas of the element, and $A_p'$ and $A_n'$ are surface areas of a water cooling part. According to the experimental data, temperature characteristics can be approximated linearly. From Equation (9) using the symbol <> indicating an average, the internal resistance and the generated voltage are represented as in Equation (10).
[Math. 9]

$$\langle \rho_p \rangle = \frac{\rho_p(0) + \rho_p(L)}{2} \qquad \langle \rho_n \rangle = \frac{\rho_n(0) + \rho_n(L)}{2}$$

$$\langle S_p \rangle = \frac{S_p(0) + S_p(L)}{2} \qquad \langle S_n \rangle = \frac{S_n(0) + S_n(L)}{2} \qquad \cdots (9)$$

[Math. 10]

$$r_p = \langle \rho_p \rangle \frac{L}{A_p} \qquad r_n = \langle \rho_n \rangle \frac{L}{A_n} \qquad \cdots (10)$$

$$V_p = \langle S_p \rangle \Delta T_p \qquad V_n = -\langle S_n \rangle \Delta T_n$$

Using Equations (9) and (10), the maximum power output $P_{max}$ of power generation is represented as in Equation (11), and the maximum power output per unit area is represented as in Equation (12).
[Math. 11]

$$P_{max} = \frac{1}{4} \frac{(V_p + V_n)^2}{r_p + r_n} = \frac{1}{4L} \frac{(\langle S_p \rangle \Delta T_p - \langle S_n \rangle \Delta T_n)^2}{\frac{\langle \rho_p \rangle}{A_p} + \frac{\langle \rho_n \rangle}{A_n}} \qquad \cdots (11)$$

[Math. 12]

$$\frac{P_{max}}{A_{tot}} = \alpha \frac{(\Delta T)^2}{4} \frac{v(L)}{g(t)} \qquad \cdots (12)$$

Here, $\alpha$ is a filling factor and is defined as in Equation (13).
[Math. 13]

$$\alpha \equiv \frac{A}{A_{tot}} \qquad \cdots (13)$$

Here, an area A is represented as in Equation (14), and each $A_p$ and $A_n$ can be represented as in Equation (15) by using the cross-sectional area ratio t.
[Math. 14]

$$A = A_p + A_n \qquad \cdots (14)$$

[Math. 15]

$$A_p = tA \qquad A_n = (1 - t)A \qquad \cdots (15)$$

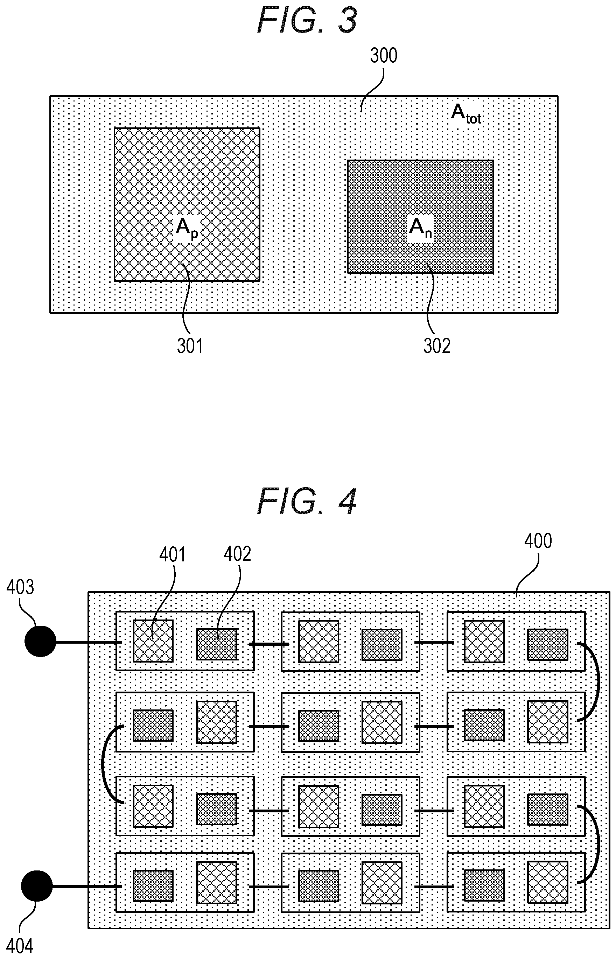

Fig. 3 is a diagram schematically showing a state of the cross-sectional areas $A_p$ and $A_n$. In Fig. 3, a shape of the cross-sectional area is represented by a square; however, according to a theoretical formula, the result is irrelevant to the shape of the cross-sectional area and a circular, elliptical, or polygonal shape is also possible. For relaxing distortion, a circular shape is considered to be preferable.

Fig. 4 is a diagram showing a state of cross-sectional areas in a multiple-pair module. In the multiple-pair module, as shown in Fig. 4, the filling factor $\alpha$ is obtained by (a sum of the cross-sectional areas of the p-type element and the n-type element) ÷ (a total bottom area of the module). Using the above, g(t) and v(L) are defined as in Equations (16) and (17), respectively.

[Math. 16]

$$g(t) \equiv A \left\{ \frac{\langle \rho_p \rangle}{A_p} + \frac{\langle \rho_n \rangle}{A_n} \right\} = \frac{\langle \rho_p \rangle}{t} + \frac{\langle \rho_n \rangle}{1-t} \quad \cdots (16)$$

[Math. 17]

$$v(L) \equiv \frac{\{\langle S_p \rangle f_p(L) - \langle S_n \rangle f_n(L)\}^2}{L} \quad \cdots (17)$$

Here, $f_p$ (L) and $f_n$ (L) are defined by Equation (18).

[Math. 18]

$$f_p(L) \equiv \frac{1}{1 + \left( \frac{1}{h_p} + \frac{1}{h_p^*} \right) \frac{\kappa_p}{L}} \qquad f_n(L) \equiv \frac{1}{1 + \left( \frac{1}{h_n} + \frac{1}{h_n^*} \right) \frac{\kappa_n}{L}} \quad \cdots (18)$$

In order to maximize the power generation output per unit area $P_{max}/A_{tot}$, it is only necessary to minimize (t) and maximize v(L). First, g(t) is minimized in a state as shown in Equation (19).

[Math. 19]

$$t_0 = \frac{\sqrt{\langle \rho_p \rangle}}{\sqrt{\langle \rho_p \rangle} + \sqrt{\langle \rho_n \rangle}} \qquad 1 - t_0 = \frac{\sqrt{\langle \rho_n \rangle}}{\sqrt{\langle \rho_p \rangle} + \sqrt{\langle \rho_n \rangle}} \quad \cdots (19)$$

This means that the cross-sectional area ratio is determined only from the electrical resistivity as shown in Equation (20).

[Math. 20]

$$A_p : A_n = \sqrt{\langle \rho_p \rangle} : \sqrt{\langle \rho_n \rangle} \quad \cdots (20)$$

Then, a minimum value of g(t) is represented as in Equation (21).

[Math. 21]

$$g(t_0) = (\sqrt{\langle \rho_p \rangle} + \sqrt{\langle \rho_n \rangle})^2 \quad \cdots (21)$$

Next, for maximizing v(L), a numerical calculation was performed to avoid a complicated equation.

Thermoelectric performance of the silicide material based on the binary system (p-type thermoelectric element MnSi$_{1.7}$ and n-type thermoelectric element Mg$_2$Si) was calculated. Assuming that a high temperature part is at 500°C and a low temperature part is at 25°C, the following physical property values were used.

$S_p$ = 120 to 200 μV/K, $k_p$ = 2 to 2 W/Km, $\rho_p$ = 12 to 20 μΩm, $S_n$ = -100 to -220 μV/K, $k_n$ = 6.5 to 4 W/Km, and $\rho_n$ = 5 to 12 μΩm.

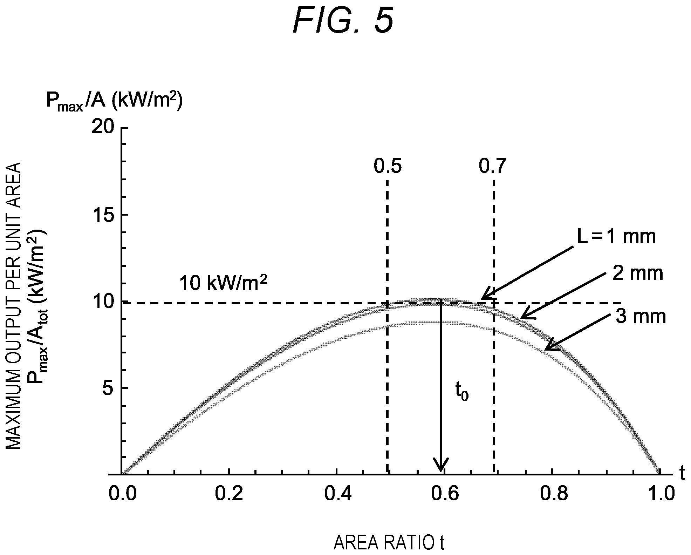

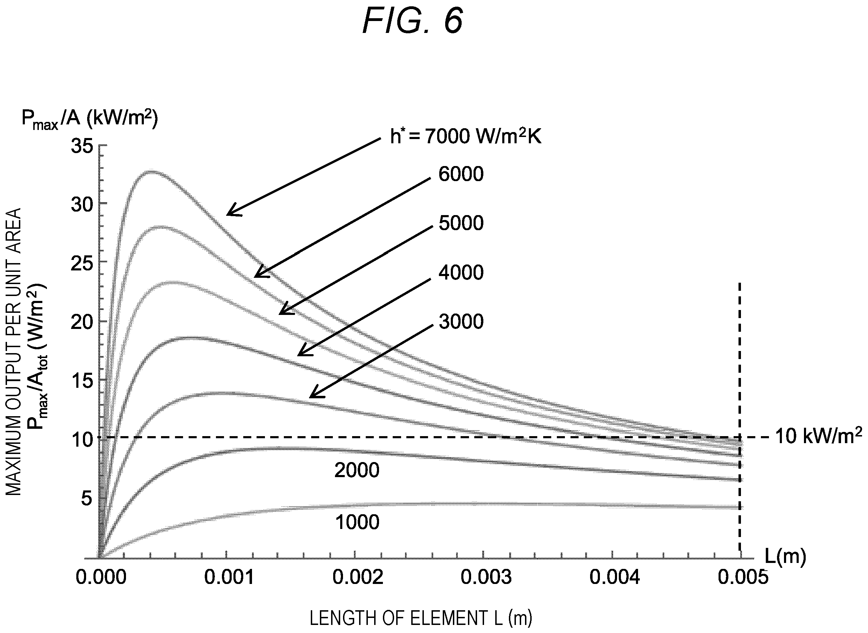

Fig. 5 is a graph showing the calculation results of the maximum power output per unit area $P_{max}/A_{tot}$ with respect to the cross-sectional area ratio t. Fig. 5 shows that the maximum output per unit area $P_{max}/A_{tot}$ is the largest at around t = 0.6. The value at t = 0.6 is determined only by the electrical resistivity. Note that Fig. 6 shows the results in a case where the effective heat transfer coefficient is 2,200 W/m$^2$K, which matches a condition that the maximum power output is exactly 10 kW/m$^2$. In this case, Fig. 5 shows that a maximum performance can be obtained where 0.5 < t < 0.7.

Fig. 6 is a graph showing the calculation result of the maximum power output per unit area $P_{max}/A_{tot}$ with respect to the length L of an element, using the effective heat transfer coefficient h* as a parameter. The graph shows that 10 kW/m$^2$ (equivalent to a conversion efficiency of 5%) can be achieved when the effective heat transfer coefficient is h* > 2,200 W/m$^2$K. The Microelectronics Package Handbook (p.138, Nikkei Business Publications, Inc.) describes that the heat transfer coefficient of forced water cooling is represented as h'= 3,000 to 7,000 W/m$^2$K. This indicates that even when h' = 3,000 W/m$^2$K, where the heat transfer coefficient is worst, the maximum power output of 10 kW/m$^2$ can be achieved if Equation (22) is satisfied for the cross-sectional area ratio.

[Math. 22]

$$\frac{A_p'}{A_p} \geqq 0.73 \qquad \frac{A_n'}{A_n} \geqq 0.73 \quad \cdots (22)$$

[Example 2]

Experiments were conducted on a single-pair module and a nine-pair module actually manufactured, and the following results were obtained for the single-pair module.

[Table 1]

| Module name | Length of Element (mm) | Cross-sectional area of p-type element (mm$^2$) | Cross-sectional area of n-type element (mm$^2$) | Maximum power output (kW/m$^2$) |
|---|---|---|---|---|
| Module-1 | 3.5 | 16 | 16 | 10.8 |
| Module-2 | 3.5 | 16 | 11.56 | 11.0 |
| Module-3 | 3 | 16 | 11.56 | 11.6 |
| Module-4 | 2 | 16 | 11.56 | 14.3 |
| Module-5 | 1 | 16 | 11.56 | 13.3 |
| Module-6 | 0.5 | 16 | 11.56 | 3.5 |

A difference between Module-1 and Module-2 is the cross-sectional area ratio, which corresponds to t = 0.5 for Module-1 and t = 0.6 for Module-2. As predicted by the calculation of cross-sectional area ratio optimization, the output was slightly higher at t = 0.6 as an asymmetric area ratio.

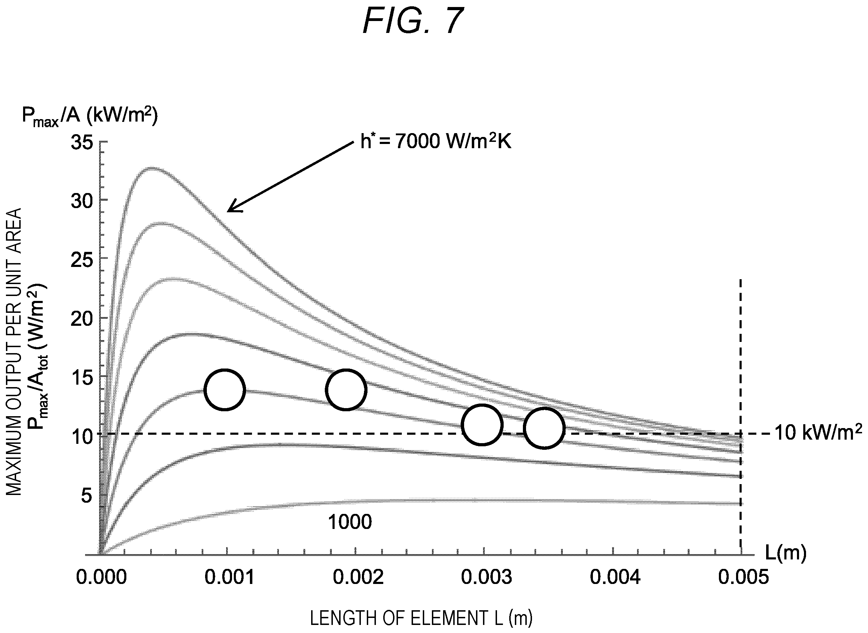

Fig. 7 is a diagram showing the results of Module-2 to Module-6. In Fig. 7, the results are plotted as white circles. This indicates that the effective heat transfer coefficient is within a range where h* = 3,000 W/m$^2$K to 4,000 W/m$^2$K, which is consistent with the calculation results. The experimental results are considered to show that changes with respect to the length L are different from the calculated results due to the temperature differences for technical reasons such as the forced water cooling. Further improvement in characteristics is expected by increasing the cross-sectional area of a heat discharging part (low temperature part).

Reference Signs List

100 single-pair thermoelectric conversion module
101 high temperature electrode
102 p-type thermoelectric conversion element
103 n-type thermoelectric conversion element
104 low temperature electrode
105 low temperature electrode
106 water flow
$T_H$ heat source supplying heat (high temperature)
$T_C$ cooling source exhausting heat (low temperature)
300 total bottom area $A_{tot}$ of single-pair module
301 cross-sectional area $A_p$ of p-type thermoelectric conversion element
302 cross-sectional area $A_n$ of n-type thermoelectric conversion element

400 total bottom area $A_{tot}$ of 12-pair module
401 cross-sectional area $A_p$ of p-type thermoelectric conversion element (sum of areas of 12 pairs is $12A_p$)
402 cross-sectional area $A_n$ of n-type thermoelectric conversion element (sum of areas of 12 pairs is $12A_n$)
403 output (positive electrode)
404 output (negative electrode)

## Claims

1. A thermoelectric assembly, comprising a thermoelectric conversion module and heat supply units,

   wherein the thermoelectric conversion module (100) comprises a p-type thermoelectric conversion material (102) and an n-type thermoelectric conversion material (103), each of which is a silicide material based on a binary system;
   wherein the thermoelectric assembly includes multiple thermoelectric conversion modules,
   wherein the heat supply units are disposed on an upper surface and a lower surface in a thickness direction of the thermoelectric conversion module (100), are configured to impart a temperature difference to the thermoelectric conversion module (100), and are configured to supply heat for power generation by Seebeck effect of the p-type and n-type thermoelectric conversion materials (102, 103) and cooling source discharging heat,
   wherein the p-type and n-type thermoelectric conversion materials (102, 103) have a cross-sectional area ratio t satisfying:
   the p-type thermoelectric conversion material (102) :

   the n-type thermoelectric conversion material (103) =
   t:(1-t),
   **characterized in that** $0.5 < t < 0.7$, and a length L of a thermoelectric element satisfying $L \leq 5$ mm,
   wherein, when cross-sectional areas where electrodes (105) for discharging the heat from the p-type thermoelectric conversion material (102) having a cross-sectional area $A_p$ and the n-type thermoelectric conversion material (103) having a cross-sectional area $A_n$ are in contact with the cooling source are $A_p$' and $A_n$', respectively, the thermoelectric conversion module (100) has an area ratio of $A_p'/A_p \geq 0.73$ and $A_n'/A_n \geq 0.73$.

2. The thermoelectric assembly according to claim 1, **characterized in that** the p-type thermoelectric conversion material (102) has the cross-sectional area ratio $t = 0.6$.

## Patentansprüche

1. Thermoelektrische Anordnung, umfassend ein thermoelektrisches Umwandlungsmodul und Wärmeversorgungseinheiten,

   wobei das thermoelektrische Umwandlungsmodul (100) ein thermoelektrisches Umwandlungsmaterial (102) vom p-Typ und ein thermoelektrisches Umwandlungsmaterial (103) vom n-Typ umfasst, von denen jedes ein Silicidmaterial ist, das auf einem binären System basiert;
   wobei die thermoelektrische Anordnung mehrere thermoelektrische Umwandlungsmodule umfasst,
   wobei die Wärmeversorgungseinheiten auf einer oberen Oberfläche und einer unteren Oberfläche in einer Dickerichtung des thermoelektrischen Umwandlungsmoduls (100) angeordnet sind, die ausgelegt sind, um eine Temperaturdifferenz an dem thermoelektrischen Umwandlungsmodul (100) bereitzustellen, und ausgelegt sind, um Wärme zur Leistungserzeugung durch den Seebeck-Effekt der thermoelektrischen Umwandlungsmaterialien vom p-Typ und n-Typ (102, 103) und Kühlquellen-Abwärme bereitzustellen,
   wobei die thermoelektrischen Umwandlungsmaterialien vom p-Typ und n-Typ (102, 103) ein Querschnittsflächenverhältnis t aufweisen, das Folgendes erfüllt:

   das thermoelektrische Umwandlungsmaterial (102) vom p-Typ: das thermoelektrische Umwandlungsmaterial (103) vom n-Typ = t:(1-t),
   **dadurch gekennzeichnet, dass** $0,5 < t < 0,7$ ist und eine Länge L eines thermoelektrischen Elements $L \leq 5$ mm erfüllt,
   wobei, wenn die Querschnittsflächen, in denen Elektroden (105) zum Abführen der Wärme von dem thermoelektrischen Umwandlungsmaterial (102) vom p-Typ, das eine Querschnittsfläche $A_p$ aufweist, und von dem thermoelektrischen Umwandlungsmaterial (103) vom n-Typ, das eine Querschnittsfläche $A_n$ aufweist, mit der Kühlquelle in Kontakt stehen, $A_p$' bzw. $A_n$' sind, das thermoelektrische Umwandlungsmodul (100) ein Flächenverhältnis von $A_p$'/$A_p \geq 0,73$ und von $A_n$'/$A_n \geq 0,73$ aufweist.

**2.** Thermoelektrische Anordnung nach Anspruch 1, **dadurch gekennzeichnet, dass** das thermoelektrische Umwandlungsmaterial (102) vom p-Typ das Querschnittsflächenverhältnis von t = 0,6 aufweist.

**Revendications**

**1.** Ensemble thermoélectrique, comprenant un module de conversion thermoélectrique et des unités de fourniture de chaleur,

dans lequel le module de conversion thermoélectrique (100) comprend un matériau de conversion thermoélectrique de type p (102) et un matériau de conversion thermoélectrique de type n (103), chacun étant un matériau de siliciure basé sur un système binaire ;
dans lequel l'ensemble thermoélectrique inclut de multiples modules de conversion thermoélectrique,
dans lequel les unités de fourniture de chaleur sont disposées sur une surface supérieure et une surface inférieure dans une direction d'épaisseur du module de conversion thermoélectrique (100), sont configurées pour conférer une différence de température au module de conversion thermoélectrique (100), et sont configurées pour fournir de la chaleur pour la production d'énergie par effet Seebeck des matériaux de conversion thermoélectrique de type p et de type n (102, 103) et par une source de refroidissement évacuant de la chaleur,
dans lequel les matériaux de conversion thermoélectrique de type p et de type n (102, 103) présentent un rapport d'aires de section transversale t satisfaisant :

le matériau de conversion thermoélectrique de type p (102) : le matériau de conversion thermoélectrique de type n (103) =
t :(1-t),
**caractérisé en ce que** $0,5 < t < 0,7$, et une longueur L d'un élément thermoélectrique satisfaisant $L \leq 5$ mm, dans lequel, lorsque des aires de section transversale où les électrodes (105) pour évacuer de la chaleur à partir du matériau de conversion thermoélectrique de type p (102) présentant une aire de section transversale $A_p$ et du matériau de conversion thermoélectrique de type n (103) présentant une aire de section transversale $A_n$ sont en contact avec la source de refroidissement et sont respectivement $A_p$' et $A_n$', le module de conversion thermoélectrique (100) présente un rapport d'aires $A_p$'/$A_p \geq 0,73$ et $A_n$'/$A_n \geq 0,73$.

**2.** Ensemble thermoélectrique selon la revendication 1, **caractérisé en ce que** le matériau de conversion thermoélectrique de type p (102) présente le rapport d'aires de section transversale t = 0,6.

EP 3 855 518 B1

# FIG. 1

# FIG. 2

$$P_{out} = I_{out} V_{out} = I_{out}^2 R$$

10

## FIG. 3

## FIG. 4

# FIG. 5

FIG. 6

EP 3 855 518 B1

*FIG. 7*

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2017057259 A1
- EP 1970972 A1
- JP 2015122476 A
- JP H11274577 A